**Europäisches Patentamt**

**European Patent Office**

**Office européen des brevets**

(19)

(11) Veröffentlichungsnummer: **0 279 216**
**A1**

(12) **EUROPÄISCHE PATENTANMELDUNG**

(21) Anmeldenummer: 88100969.0

(22) Anmeldetag: 22.01.88

(51) Int. Cl.⁴: **B23K 20/10**

(30) Priorität: 09.02.87 DE 3703943

(43) Veröffentlichungstag der Anmeldung:
24.08.88 Patentblatt 88/34

(84) Benannte Vertragsstaaten:
AT BE CH DE FR GB IT LI LU NL SE

(71) Anmelder: Siemens Aktiengesellschaft Berlin
und München
Wittelsbacherplatz 2
D-8000 München 2(DE)

(72) Erfinder: von Raben, Klaus Ulrich, Dr.
Finkenstrasse 23
D-8011 Baldham(DE)
Erfinder: Ludwig, Rupert
Münchner Strasse 24
D-8031 Alling(DE)

(54) **Gerät zur Messung von Bondparametern.**

(57) Um eine gleichbleibende Qualität der montierten
Bausteine zu gewährleisten, müssen diese Bonder
entsprechend der der Erfindung zugrunde liegenden
Aufgabe in geeigneten Zeitintervallen bezüglich der
Bondkraft, der Ultraschall-Amplitude und der Bondzeit überwacht und eventuell nachgeregelt werden.
Außerdem ist großer Wert auf einen flexiblen Aufbau
zu legen. Die Aufnahme der Meßwerte geschieht
nach der Erfindung mit einem mobilen, piezoelektrischen Sensor auf dem Heiztisch, der nicht höher ist
als die üblich bearbeiteten integrierten Schaltkreise.
Anwendungsgebiete sind alle Ultraschall-Bonder für
integrierte Schaltkreise.

FIG 1

EP 0 279 216 A1

## Gerät zur Messung von Bondparametern.

Die Erfindung betrifft ein Gerät zur Messung und Überwachung der Kraft-und Ultraschalleinstellung in geeigneten Zeitintervallen von Bondmaschinen, insbesondere Bondern, die mit Ultraschall arbeiten, und vorzugsweise zum Bonden von Anschlußdrähten dienen, die von Halbleiterkörpern auf Leiterbahnen nichtleitender Substrate führen.

Unter Bonden wird grundsätzlich ein mechanisches Verbindungsverfahren verstanden, das gleichzeitig auch einen elektrischen Kontakt der zu verbindenden Teile herstellt. Dies wird beim Drahtbonden dadurch erreicht, daß zwei mechanisch zunächst ungleiche Teile (zum Beispiel Chip und Draht) durch Anpassung ihrer Oberflächenstruktur miteinander verbunden werden. Dabei wird mindestens bei einem Teil eine Formänderung hergestellt.

Diese Formänderung kann im einfachsten Falle durch reine Krafteinwirkung erfolgen. Durch zusätzliche Einwirkung von Ultraschallenergie kann dann sowohl die Kraft als auch die Temperatur verringert werden.

In der Mikroelektronik werden außerordentlich hohe Ansprüche an die Qualität der Verbindung gestellt. Die Kontaktierung von integrierten Schaltkreisen (IC) geschieht mittels dünner (ca. 17 bis 50 µm) Gold-oder Aluminiumdrähte. Diese Drähte werden durch Bonder automatisch auf den IC und den Trägerrahmen aufgebracht. Je kleiner diese werden, um so genauer müssen die Maschinen (Kontaktiermaschinen oder Bonder) arbeiten, die die Anschlußflächen (pads) automatisch erkennen und anschließend die Drahtverbindungen herstellen. Um zu garantieren, daß die Kontaktiermaschinen während des täglichen Betriebes diese Genauigkeit einhalten, ist es notwendig, gewisse elementare Funktionen überwachen zu können.

Pro Bauform und pro Kontaktiermaschine ist in aller Regel ein optimierter Bereich der Bondparameter (Bondkraft, US-Amplitude, Bondzeit und Bondtemperatur) zu ermitteln, der die an das Bauteil gestellten Qualitätsanforderungen garantieren kann. Dieses Set von Parametern variiert naturgemäß von Bauform zu Bauform und streut ebenfalls in Bezug auf die Kontaktiermaschinen. Nur durch regelmäßige Überwachung und evtl. Nachregelung dieser Kontaktiermaschinen kann im Prinzip die Einhaltung dieses optimierten Arbeitsbereiches sichergestellt werden.

Der Erfindung liegt die Aufgabe zugrunde, das eingangs definierte Gerät zu konzipieren, um bei einer Kraftmessung an Bondern die beim Bonden auftretenden statischen und dynamischen Kräfte, die Ultraschall-Amplitude und Bondzeit während eines einzigen simulierten Bondvorganges zu messen. Dabei ist großer Wert auf einen flexiblen Aufbau zu legen, um den Kraftaufnehmer leicht an verschiedenen Bondern anbringen zu können.

Insbesondere sollen einzelne Phasen und Details, wie zum Beispiel Einschwingvorgänge oder zeitliche Abläufe, untersucht werden. Darüber hinaus sollen einzelne Bonder im Betriebszustand auf die für sie spezifischen Parameter eingestellt und danach mit diesen Parametern betrieben werden.

In der DE OS 32 33 629 ist ein Verfahren und eine Einrichtung zur Herstellung von Verbindungen mittels Ultraschall beschrieben und dargestellt. Dabei handelt es sich um eine stationäre Einrichtung, mit der die Kraft bestimmt und überwacht wird, die zur Trennung des Verbindungswerkzeugs von einem der an der Verbindung teilnehmenden Bauelemente nach Beendigung des Verbindungsvorganges erforderlich ist. Das setzt aber einen Eingriff in die Maschine und einen Umbau voraus, der bei vielen Maschinen entweder unmöglich oder nur mit realtiv großem Aufwand durchführbar ist.

Bei der in der US PS 3 857 279 beschriebenen Vorrichtung handelt es sich ebenfalls um ein stationär in die Maschine integriertes Meßsystem, das Oberwellen des Ultraschalls mißt und auswertet. Eine Kraftmessung findet nicht statt.

Die der Erfindung zugrundeliegende Aufgabe wird gemäß den kennzeichnenden Merkmalen der Patentansprüche gelöst. Die üblicherweise bearbeiteten ICs sind nur wenige Millimeter, zum Beispiel bis 3 mm, hoch.

Durch die vorliegende Erfindung wird ein Verfahren beschrieben, mit dem die Einstellung der Bondkraft und der Ultraschall-Amplitude aller Ultraschall-Bonder gemessen und damit überwacht werden kann. Der dabei verwendete Kraftaufnehmer, der auf piezoelektrischer Basis arbeitet, hat gegenüber herkömmlichen, auf DMS (Dehnungsmeßstreifen) beruhenden Kraftmessern den Vorteil der weglosen Kraftmessung, des geringen Platzbedarfs und der Möglichkeit, gleichzeitig mit der Kraft auch die Ultraschall-Amplitude zu messen. Mit diesem mobilen Sensor ist es möglich, einen Kraftaufnehmer zu konzipieren, der schnell und problemlos in gängige Bonder eingespannt werden kann.

Der Sensor kann in einem flachen Gehäuse, z. B. einem DIC-Gehäuse (Dual-in-line ceramic) untergebracht sein und auf dem Heiztisch des Bonders direkt unterhalb der Bonddüse anstelle eines zu bondenden IC plaziert werden. Durch die Kleinheit und geringe Höhe des Sensors und des Gehäuses kann dies ohne Umbau des Bonders geschehen.

Mit der Erfindung wurde ein mobiles, von der Kontaktiermaschine unabhängiges und handliches Instrument beschrieben, das die routinemäßige Überwachung und Einstellung der Bondparameter, Bondkraft, US-Amplitude und Bondzeit ermöglicht. Der piezoelektrische Sensor nimmt diese Parameter auf, die anschließend als elektrische Größen weiterverarbeitet werden. Mit Hilfe eines Speicheroszillographen können diese Größen sofort sichtbar gemacht und ausgewertet werden.

Die Erfindung wird anhand der Figuren erläutert. Es zeigen:

Figur 1 eine Vorrichtung zur Kraft-und Ultraschallmessung und

Figur 2 ein Oszillogramm des Kraft-und Ultraschallsignales.

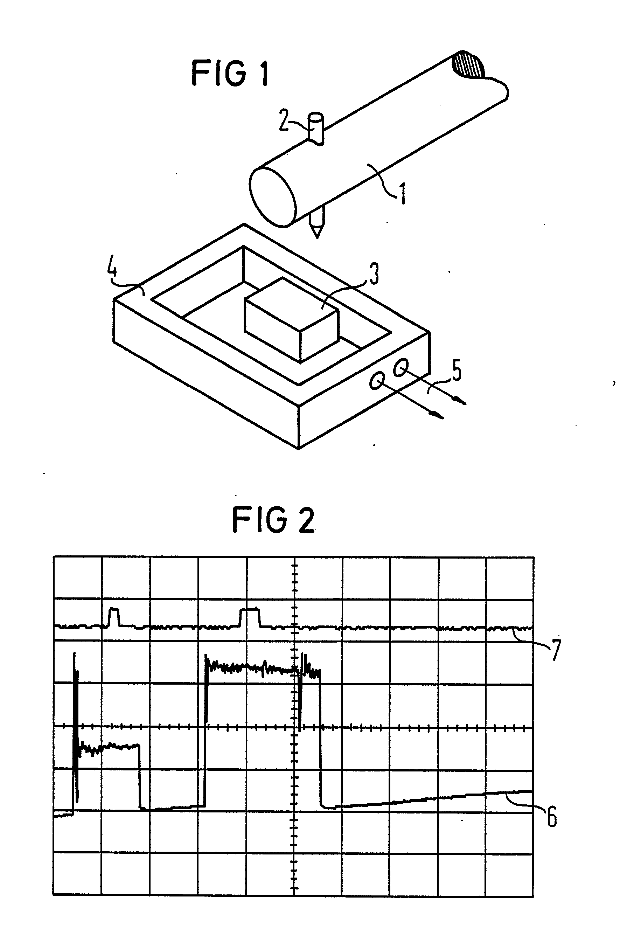

In der Figur 1 ist schematisch ein Bondarm 1 mit einer Bondspitze 2 dargestellt. Direkt unter der Bondspitze befindet sich ein Sensor 3 in einem Gehäuse 4. Die Pfeile 5 weisen in Richtung eines nicht dargestellten Verstärkers.

Bei ausgeschalteter Heizung (Heiztisch auf Raumtemperatur) ersetzt der Sensor den zu bondenden IC. Die Kontaktiermaschine führt den Bondvorgang durch, ohne aber (wegen fehlender Temperatur) zu bonden ( = simulierter Bondvorgang).

Das Oszillogramm nach der Figur 2 zeigt mit der Kurve 6 den typischen Verlauf der Bondkraft, mit dem die Bondspitze auf den Sensor drückt, und mit der Kurve 7 den Verlauf der Ultraschallamplitude. Auf der Abszisse ist die Zeit aufgetragen, so daß aus der Signallänge in Kurve 6 die Andrückzeit des Bondarmes und aus der Kurve 7 die Bondzeit abgelesen werden kann. Deutlich sind die beiden Bondvorgänge im zeitlichen Verlauf des Kraftsignales zu erkennen.

Der erste Kraftimpuls der Kurve spiegelt das Andrücken des "balls", der zweite das des "wedge" wieder. Wie ersichtlich, ist der Vorgang des Bondens kein statischer Prozeß, d. h. der Bondarm drückt nicht ständig mit einer konstanten Kraft auf den IC oder Sensor, sondern es läuft ein dynamischer Vorgang ab. Darunter versteht man, daß während des Bondvorganges grob drei Bereiche des Kraftverlaufes unterschieden werden können:

1) das Aufsetzen des Bondarmes auf den IC,

2) der Einschwingvorgang des Bondarmes und

3) der statische Bereich, in dem der Bondarm ruhig auf den IC aufliegt und somit eine konstante Kraft ( = Bondkraft) ausübt.

Je nach Einstellung der Kontaktiermaschinen, nach Art und Weise der Krafterzeugung im Bonder (Federkraft, magnetodyn. Prinzip) und nach der Zeitdauer des gesamten Vorganges können die einzelnen Bereiche unterschiedliches Gewicht erlangen.

Das von der Piezokeramik des Sensors 3 abgegebene Signal wird vorzugsweise in einem nicht dargestellten Operationsverstärker verstärkt. Über unterschiedliche Integrationskondensatoren im Verstärkerteil kann die Empfindlichkeit des Kraftmessers verändert und dem jeweiligen Kraftbereich angeglichen werden. Durch einen Tiefpaß und einen Durchlaßpaß wird das verstärkte Signal in die in der Figur 2 wiedergegebenen Anteile zerlegt.

Aus den in der Figur 2 wiedergegebenen Linienzügen können die Größe der Bondkraft, das Einschwingverhalten des Bondarmes, die Ultraschallamplitude, die Bondzeit und das Ultraschallsignal entnommen und somit separat gemessen und untersucht werden. Ferner können die Signale nach elektronischer Weiterverarbeitung digitalisiert und als Meßwerte direkt zur Anzeige gebracht werden. Damit kann die Bondkraft und die Ultraschall-Einstellung des Generators direkt nach dem simulierten Bondvorgang als digitaler Wert abgelesen werden. Dadurch ist es möglich, in einem Arbeitsgang die Bondkraft und die Ultraschall-Amplitude an der Bondspitze von Bondern, die mit Ultraschall arbeiten, zu messen. Ferner können diese Parameter überwacht und mit denen von anderen Bondern verglichen werden.

## Ansprüche

1. Gerät zur Messung und Überwachung der Kraft-und Ultraschalleinstellung und der Bondzeit von Bondmaschinen, insbesondere Bondern, die mit Ultraschall arbeiten und vorzugsweise zum Bonden von Anschlußdrähten dienen, die von Halbleiterkörpern auf Leiterbahnen nichtleitender Substrate führen, **dadurch gekennzeichnet,** daß zur Messung dieser Werte unter die Spitze (2) der Bonddüse auf den Heiztisch ein mobiler, von der Bondmaschine unabhängiger, piezoelektrischer Sensor (3) aufgelegt wird, der das Bondkraftsignal, das US-Signal und die Bondzeit mißt und während eines nachvollzogenen Bondvorganges registriert und daß diese beiden Signale einem Verstärker zugeführt werden, der mittels Filtern beide Signale (6, 7) elektronisch trennt und einer Vorrichtung zur Anzeige und Auswertung zuführt.

2. Gerät nach Anspruch 1, **dadurch gekennzeichnet,** daß der piezoelektrische Sensor (3) mit Gehäuse (4) nicht höher ist als die üblich bearbeiteten integrierten Schaltkreise (IC).

3. Gerät nach Anspruch 1, **dadurch gekennzeichnet,** daß der Verstärker als hochohmiger Verstärker ausgebildet ist und daß sich an den Verstärker zwei Filter anschließen, und zwar ein Tiefpaß (ca. 1 kHz) für das Kraftsignal und ein Durchlaßpaß (ca. 60 kHz) für das Ultraschallsignal.

4. Gerät nach Anspruch 1, **dadurch gekennzeichnet**, daß als Vorrichtung zur Anzeige ein an sich bekannter Speicheroszillograph mit anschließendem Schreiber oder Plotter zur Auswertung vorgesehen ist.

5. Gerät nach Anspruch 1, **dadurch gekennzeichnet**, daß als Vorrichtung zur Anzeige eine elektronische Anzeige vorgesehen ist, die digital die Bondkraft, die Ultraschall-Amplitude und die Bondzeit des Bondvorganges angibt.

# FIG 1

# FIG 2

**Europäisches Patentamt**

# EUROPÄISCHER RECHERCHENBERICHT

Nummer der Anmeldung

EP 88 10 0969

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y,D | DE-A-3 233 629 (RAYTHEON CO.)<br>* Seite 10, Zeile 6 - Seite 12; Abbildungen 1-4 * | 1-4 | B 23 K 20/10 |
| A,D | | 5 | |
| | --- | | |
| Y,D | US-A-3 857 279 (T. SALZER et al.)<br>* Spalte 3, Zeilen 20-35; Spalte 4, Zeile 65 - Spalte 6, Zeile 26; Abbildungen 1,5,6 * | 1-4 | |
| | ----- | | |

|  |  |  | RECHERCHIERTE SACHGEBIETE (Int. Cl.4) |
|---|---|---|---|
| | | | B 23 K<br>H 01 L |

Der vorliegende Recherchenbericht wurde für alle Patentansprüche erstellt

| Recherchenort | Abschlußdatum der Recherche | Prüfer |
|---|---|---|
| DEN HAAG | 13-05-1988 | ARAN D.D. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
............................................................
& : Mitglied der gleichen Patentfamilie, übereinstimmendes Dokument

EPO FORM 1503 03.82 (P0403)